# EUROPEAN PATENT APPLICATION

(11) **EP 4 826 999 A1**
(43) Date of publication of application: **21.10.2026**
(21) Application number: 25305563.6
(22) Date of filing: 16.04.2025
(51) Int. Cl.: H03M 3/00

(54) **A MULTI-BIT DELTA-SIGMA MODULATOR**

(71) Applicant: Scalinx, 75013 Paris (FR)
(72) Inventor: Marie, Hervé, 14000 Caen (FR); Le, Nguyen Trieu Luan, 14123 Cormelles Le Royal (FR)
(74) Representative: Murgitroyd & Company

(57) **Abstract**

A MB-DSM comprising: an integrator configured to receive an analogue input signal and output an integrated analogue signal; a quantizer configured to receive and convert the integrated analogue signal to N 1-bit digital signals, wherein the quantizer comprises N comparator assemblies, each comparator assembly configured to at least compare the integrated analogue signal to a corresponding threshold value and output a respective one of the N 1-bit digital signals; and a first multi-bit feedback digital-to-analog converter (FB-DAC) configured to convert the N 1-bit digital signals to N analogue feedback signals that are coupled to an input of the integrator, wherein the first multi-bit FB-DAC comprises N 1-bit current steering DACs, each 1-bit current steering DAC configured to convert a respective one of the N 1-bit digital signals to a respective one of the N analogue feedback signals; wherein the MB-DSM is switchable between a normal mode and a calibration mode.

## Description

### Field of the invention

This invention relates to a multi-bit Delta-Sigma modulator and in particular a method of calibrating one or more return digital-to-analogue converters of such a multi-bit Delta-Sigma modulator.

### Background to the invention

A conventional Delta-Sigma modulator (DSM) comprises an integrator which may function as an analogue loop filter (e.g., a low-pass filter or a band-pass filter), a quantizer and at least one return or feedback digital-to-analogue converter (FB-DAC). This converter comprises, in the case of a multi-bit modulator, several current or voltage sources, having mismatch errors, where these errors may vary depending on the environmental conditions: temperature, power supply voltage, or aging of the components. The interest of a DSM resides in its high output resolution possible (up to 16, 24, 32 bits, or even more) for input signals with a moderate bandwidth. However, in a multi-bit DSM (MB-DSM), the performance characteristics are limited by the mismatch errors of the FB-DAC.

Various techniques are known for improving the linearity of the FB-DAC to reduce or remove the mismatch errors. However, all of the existing techniques require generation of a test signal which is used to estimate the mismatch errors of the FB-DAC and at least one additional circuit element which is used to allow the calibration operation to be performed in parallel with the normal data conversion operation. The additional circuit elements often include additional unary DAC units (which are current-steering DACs that use a single current element for each quantization step), and/or additional comparators in the quantizer. The presence of such additional circuit elements introduces parasitic effects, which hinder the speed and performance of a MB-DSM.

For example, the calibration techniques disclosed in the US Patent US9906237B1 and in the scientific publication, Pascal Witte and Maurits Ortmanns, "Background DAC Error Estimation Using a Pseudo Random Noise Based Correlation Technique for Sigma-Delta Analog-to-Digital Converters", IEEE Transactions On Circuits And Systems, Volume 57, Issue 7, Pages 1500-1512, July 2010, all require one or more additional unary DAC units, which not only add significant power consumption but also lower the operating speed (e.g., multiplexor delaying the high-speed signal) and cause disturbances when a unary DAC unit is switched from the calibration mode to the normal data conversion mode.

There exists a need to further improve MB-DSMs by correcting their mismatch errors, while at the same time maintaining good performance characteristics, notably in terms of precision, of speed and of energy consumption.

### Summary of the invention

Aspects of the present disclosure are set out in the accompanying independent and dependent claims. Combinations of features from the dependent claims may be combined with features of the independent claims as appropriate and not merely as explicitly set out in the claims.

According to a first aspect of the present invention, there is provided a multi-bit delta-sigma modulator (MB-DSM) which may comprise: an integrator configured to receive an analogue input signal and output an integrated analogue signal; a quantizer configured to receive and convert the integrated analogue signal to N 1-bit digital signals, where N is an integer, wherein the quantizer may comprise N comparator assemblies, each comparator assembly configured to at least compare the integrated analogue signal to a corresponding threshold value and output a respective one of the N 1-bit digital signals; a first multi-bit FB-DAC configured to convert the N 1-bit digital signals to N analogue feedback signals that may be coupled to an input of the integrator, wherein the first multi-bit FB-DAC may comprise N 1-bit current steering DACs, each 1-bit current steering DAC configured to convert a respective one of the N 1-bit digital signals to a respective one of the N analogue feedback signals. The MB-DSM may be switchable between a normal mode in which all the N comparator assemblies may be used to convert the analogue input signal to the N 1-bit digital signals, and a calibration mode in which an analogue mismatch signal derived from a mismatch between a first 1-bit current steering DAC having received a first calibration signal from an associated first comparator assembly of the N comparator assemblies and a second 1-bit current steering DAC having received a second calibration signal having a substantially same amplitude as the first calibration signal from an associated second comparator assembly of the N comparator assemblies may be converted into M 1-bit digital signals, where M is an integer and where M<N.

The present invention introduces a novel calibration circuit for MB-DSMs that operates in a foreground mode. During the calibration phase, the modulator is configured exclusively for calibration, converting a mismatch signal derived from the difference between a reference 1-bit current steering DAC and a calibration 1-bit current steering DAC (i.e. the DAC under calibration). After the calibration phase, the modulator seamlessly transitions back to its normal conversion mode.

The present invention leverages the fact that during calibration, the analogue mismatch signal is relatively small and centered around zero. This allows the modulator to focus on the dynamic useful information contained in a subset of its output bits (e.g., middle-range bits), while the reference and calibration bits are derived from other bits. This approach minimizes disruptions and maximizes efficiency. Contrary to the prior-art, the present invention makes use of the same number of comparators and 1-bit DACs in both the normal mode and the calibration mode.

In an embodiment, the MB-DSM may further comprise an offset mechanism configured to generate an offset at an output of the quantizer to ensure that the first comparator assembly and the second comparator assembly are not required for accurately converting the difference analogue signal into the M 1-bit digital signals and a calibration signal generation mechanism configured to generate calibration signals.

The offset mechanism ensures comprehensive calibration of all bits. The offset mechanism allows dynamic toggling bits (or bits that generate dynamic transitions) to be selected dynamically while excluding the reference and calibration bits. This mechanism enables precise calibration without additional hardware complexity.

The offset at the output of the quantizer may be generated in different ways depending on the type (e.g., low-pass or band-pass) of the modulator. For low-pass modulators, the offset may be directly introduced at the output of the selected comparator assembly, e.g., by applying a forced high or low DC (or constant logic) signal to the comparator assemblies. These DC signals may propagate to the input of the modulator, thereby adjusting the behavior of the bit lines. For band-pass modulators, DC signals may not propagate effectively and thus may not be suitable. In such a case, the offset may be generated using a second FB-DAC whose output is coupled to the integrator's filter chain output.

The calibration signals may be injected at the input of the comparator assemblies of the quantizer (e.g., in the case of a band-pass modulator), rather than at the input of the 1-bit current steering DAC. By doing so, the present invention eliminates the need for additional elements, such as multiplexers in the high-speed signal path, thereby preserving the modulator's operating speed and reducing delays. However, it will be appreciated that even though the speed of operation may be reduced, injecting the calibration signals at the output of the comparator assemblies via multiplexers (e.g., in the case of a low-pass modulator) may still be useful for some applications.

In an embodiment, each of the N comparator assemblies may comprise a first parallel differential transistor pair controlled by a first current source and a second parallel differential transistor pair controlled by a second current source; wherein when enabled by the respective current source, the first parallel differential transistor pair may be operable to convert the analogue input signal to a respective one of the N 1-bit digital signals and the second parallel differential transistor pair may be operable to convert a transistor pair input signal to a calibration signal. In an embodiment, the second parallel differential transistor pair may comprise an input multiplexer configured to selectively receive, as the transistor pair input signal, a logic signal (e.g., logic HIGH signal or logic LOW signal), or a calibration signal, the input multiplexer functioning as both the calibration signal generation mechanism and the offset mechanism. In an embodiment, when the second parallel differential transistor pair is enabled and the logic signal is selected as the transistor pair input signal, the corresponding comparator assembly may be forced to output a corresponding offset signal, thereby generating the offset at the output of the quantizer.

In an embodiment, each of the N comparator assemblies may comprise an output multiplexer configured to selectively output a corresponding 1-bit digital signal or a calibration signal. In an embodiment, the output multiplexer may be further configured to selectively output one of the following signals: the corresponding 1-bit digital signal, the calibration signal, a logic signal (e.g., logic HIGH signal or logic LOW signal), the output multiplexer functioning as both the calibration signal generation mechanism and the offset mechanism. In an embodiment, when the logic signal is selected as the output of the output multiplexer, the corresponding comparator assembly may be forced to output a corresponding offset signal, thereby generating the offset at the output of the quantizer.

In an embodiment, the MB-DSM further comprising further comprising a second multi-bit FB-DAC comprising N 1-bit current steering DACs and configured to receive in the normal mode the N 1-bit digital signals from the quantizer and in the calibration mode N 1-bit digital offset signals from a logic control circuit and convert either the N 1-bit digital signals from the quantizer or N 1-bit digital offset signals from the logic control circuit to N second analogue feedback signals that are coupled to an input of the quantizer. In an embodiment, coupling the N second analogue feedback signals into the input of the quantizer in the calibration mode results in the offset at the output of the quantizer. In an embodiment, the second multi-bit FB-DAC may comprise an input multiplexer configured to selectively receive the N 1-bit digital signals from the quantizer or the N 1-bit digital offset signals from the logic control circuit, thereby enabling the switching between the normal mode and the calibration mode.

In an embodiment, the offset generated at the output of the quantizer may have different values depending on which two of the N comparator assemblies are used as the first comparator assembly and the second comparator assembly.

In an embodiment, the first calibration signal from the first comparator assembly may have a same phase as the second calibration signal from the second comparator assembly. In an embodiment, the first 1-bit current steering DAC may be configured to output a first analogue feedback signal, and the second 1-bit current steering DAC may be configured to output a second analogue feedback signal, said first analogue feedback signal having an opposite phase to said second analogue feedback signal. In an embodiment, the MB-DSM may further comprise a digital signal processor for processing the N 1-bit digital signals from the quantizer, wherein when in the calibration mode, the digital signal processor may be configured to invert the polarity of one of the first calibration signal from the first comparator assembly and the second calibration signal from the second comparator assembly.

In an embodiment, the first calibration signal from the first comparator assembly may have an opposite phase to the second calibration signal from the second comparator assembly.

In an embodiment, the first calibration signal and the second calibration signal may be a periodic square-wave signal.

According to a second aspect of the present invention, there is provided a method of calibrating a MB-DSM as claimed in any of claims 2 to 14, the method comprising: switching the MB-DSM to the calibration mode; determining that the first comparator assembly and/or the second comparator assembly are required for converting the difference analogue signal into the M 1-bit digital signals; and generating, by the offset mechanism, the offset at the output of the quantizer such that the first comparator assembly and the second comparator assembly are no longer required for converting the difference analogue signal into the M 1-bit digital signals.

It will be appreciated that any features described herein as being suitable for incorporation into one or more aspects or embodiments of the present disclosure are intended to be generalizable across any and all aspects and embodiments of the present disclosure. Other aspects of the present disclosure can be understood by those skilled in the art in light of the description, the claims, and the drawings of the present disclosure. The foregoing general description and the following detailed description are exemplary and explanatory only and are not restrictive of the claims.

### Brief Description of the Drawings

Embodiments of the present disclosure will be described hereinafter, by way of example only, with reference to the accompanying drawings in which like reference signs relate to like elements and in which:
Figure 1 shows a schematic diagram of an embodiment of the proposed MB-DSM comprising an integrator, a quantizer, and a FB-DAC, the MB-DSM being configured to be switchable between a normal mode and a calibration mode;
Figure 2 shows a schematic diagram of a first example configuration of the quantizer which comprises a plurality of first configurable comparator assemblies with configurable output states;
Figure 3 shows a schematic diagram of a second example configuration of the quantizer which comprises a plurality of second configurable comparator assemblies with configurable output states;
Figure 4 shows a schematic diagram of a different embodiment of the proposed MB-DSM in which the quantizer is configured to output two calibration signals with a same phase and a digital signal processor is configured to invert the polarity of one of the two calibration signals output from the quantizer; and
Figure 5 shows a schematic diagram of another different embodiment of the proposed MB-DSM in which one of multiple FB-DACs is configured to be switchable between the normal mode and the calibration mode and functions as an offset mechanism and a calibration signal generation mechanism when in the calibration mode.

### Detailed Description

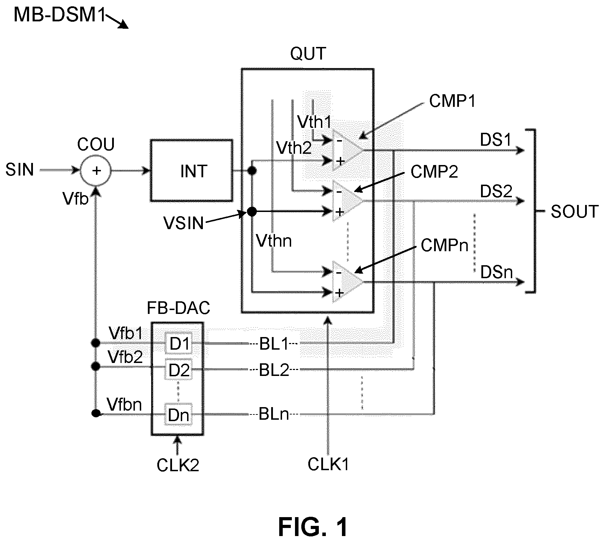

Figures 1-4 relate to embodiments of the proposed MB-DSM. The proposed MB-DSM may comprise an integrator configured to receive an analogue input signal and output an integrated analogue signal; a quantizer configured to receive and convert the integrated analogue signal to N 1-bit digital signals (where N is an integer), wherein the quantizer may comprise N comparator assemblies, each comparator assembly configured to at least compare the integrated analogue signal to a corresponding threshold value and output a respective one of the N 1-bit digital signals; and a first multi-bit FB-DAC configured to convert the N 1-bit digital signals to N analogue feedback signals that may be coupled to an input of the integrator, wherein the first multi-bit FB-DAC may comprise N 1-bit current steering DACs, each 1-bit current steering DAC configured to convert a respective one of the N 1-bit digital signals to a respective one of the N analogue feedback signals; wherein the MB-DSM may be switchable between a normal mode in which all the N comparator assemblies may be used to convert the analogue input signal to the N 1-bit digital signals, and a calibration mode in which an analogue mismatch signal derived from a mismatch between a first 1-bit current steering DAC having received a first calibration signal from an associated first comparator assembly (e.g., reference comparator assembly) of the N comparator assemblies and a second 1-bit current steering DAC having received a second calibration signal having a substantially same amplitude as the first calibration signal from an associated second comparator assembly (e.g., calibration comparator assembly) of the N comparator assemblies may be converted into M 1-bit digital signals, where M is an integer and where M<N.

With reference to Figure 1, the MB-DSM1 comprises an integrator INT configured to receive an analogue input signal SIN and output an integrated analogue signal VSIN. When functioning as a low-pass filter, the integrator INT may comprise for example an operational amplifier and a capacitor. Other known configurations of the integrator may be equally applicable.

With continued reference to Figure 1, the MB-DSM1 further comprises a quantizer QUT configured to receive and convert the integrated analogue signal VSIN to N 1-bit digital signals, where N is an integer. The quantizer QUT comprises N comparators, CMP1, CMP2, ... CMPn, each of which is configured to compare the integrated analogue signal VSIN with a corresponding threshold value, Vth1, Vth2, ... or Vthn, and depending on the comparison result, output a digital bit (e.g., a digital or logic signal), DS1, DS2, ... or DSn. In alternative embodiments, the quantizer QUT may comprise N comparator assemblies, wherein each comparator assembly may comprise a comparator (e.g., CMP1, CMP2, ...or CMPn) and one or more other elements (e.g., an output multiplexer).

The first input terminals (as indicated by "+") of all the N comparators, CMP1, CMP2, ... CMPn, are connected to the output terminal of the integrator INT while the second input terminal (as indicated by "-") of each of the N comparators, CMP1, CMP2, ... CMPn, is connected to a DC voltage forming its threshold voltage. Each comparator, CMP1, CMP2, ... or CMPn, may be configured to compare the output voltage of the integrator INT with the corresponding threshold voltage, Vth1, Vth2, ... or Vthn. If the integrated analogue signal VSIN is determined to be lower than the corresponding threshold value, Vth1, Vth2, ... or Vthn, the comparator, CMP1, CMP2, ... or CMPn, may be operable to output a logic LOW signal (e.g., DS1=0); whereas if the integrated analogue signal VSIN is determined to be equal to or higher than the corresponding threshold value, Vth1, Vth2, ... or Vthn, the comparator, CMP1, CMP2, ... or CMPn, may be operable to output a logic HIGH signal (e.g., DS1=1). Alternatively, the comparator, CMP1, CMP2, ... or CMPn, may be operable to output a logic HIGH signal (e.g., DS1=1) when the integrated analogue signal VSIN is determined to be lower than the corresponding threshold value, Vth1, Vth2, ... or Vthn, and output a logic LOW signal (e.g., DS1=0) when the integrated analogue signal VSIN is determined to be equal to or higher than the corresponding threshold value, Vth1, Vth2, ... or Vthn.

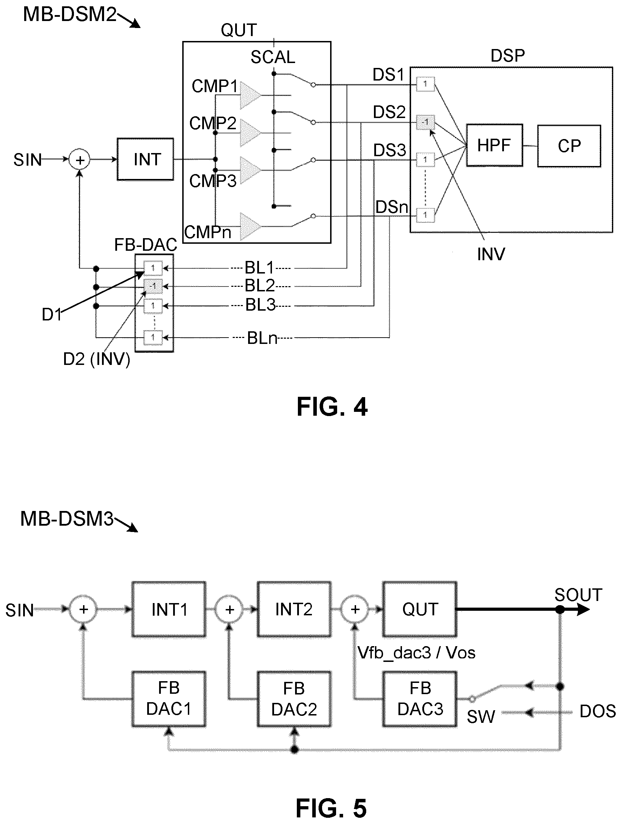

With continued reference to Figure 1, the MB-DSM1 further comprises a multi-bit FB-DAC configured to convert the digital bits, DS1, DS2, ... DSn, output from the quantizer QUT to an analogue feedback signal Vfb, which together with the analogue input signal SIN are coupled to the input of the integrator INT via a signal coupler COU which may output a sum of the received signals. In an embodiment, the signal coupler COU may be programmable to select between outputting a sum of the received signals or outputting a difference of the received signals, In a different embodiment (e.g., a high-order MB-DSM2 as shown in Figure 5), multiple (e.g., two or more) FB-DACs may be used. As shown in Figure 1, the multi-bit FB-DAC comprises N 1-bit current-steering DAC, D1, D2, ... Dn, each of which is connected to a respective one of the N comparators, CMP1, CMP2, ... CMPn, via a respective one of N bit lines, BL1, BL2, ... BLn (i.e. each bit line representing the signal path of the corresponding bit between the associated comparator and 1-bit current-steering DAC). Each of the N bit lines, BL1, BL2, ... BLn, may further comprise at least one logic circuit and at least one buffer (not shown). Each of the N 1-bit current-steering DACs, D1, D2, ... Dn, converts a respective one of the digital bits, DS1, DS2, ... DSn, to an analogue feedback signal, Vfb1, Vfb2, ...or Vfbn. All the analogue feedback signals, Vfb1, Vfb2, ... Vfbn, are then combined (or added together) to form the analogue feedback signal Vfb. In the embodiment shown in Figure 1, each analogue feedback signal is output from a single wire. It will be appreciated that one or more of the analogue signals, Vfb1, Vfb2, ... Vfbn, may be in a differential form involving two output wires.

Since the N 1-bit current-steering DACs, D1, D2, ... Dn, comprise multiple current or voltage sources (e.g., each 1-bit current-steering DAC comprises one current source) which may not have exactly same output characteristics, therefore at least some of the N analogue feedback signals, Vfb1, Vfb2, ... Vfbn, may have mismatch errors. To reduce or minimize such mismatch errors, a calibration phase may be required to calibrate one or more of the N 1-bit current-steering DACs of the MB-DSM1.

With continued reference to Figure 1, the MB-DSM1 is configured to be switchable between a normal mode (or data conversion mode) in which all the N comparators, CMP1, CMP2, ... CMPn, are used to convert the analogue input signal VSIN to the N 1-bit digital signals, DS1, DS2, ... DSn, and a calibration mode in which an analogue mismatch signal Vfb derived from a mismatch between a first 1-bit current steering DAC (e.g., D1) and a second 1-bit current steering DAC (e.g., D2) is converted into M 1-bit digital signals, where M is an integer and where M<N. The first 1-bit current steering DAC is operable to receive a first calibration signal from an associated first comparator (e.g., CMP1) of the N comparators and output a first analogue feedback signal (e.g., Vfb1). The second 1-bit current steering DAC is operable to receive a second calibration signal, which has a substantially same amplitude as the first calibration signal, from an associated second comparator of the N comparators (e.g., CMP2) and output a second analogue feedback signal (e.g., Vfb2). The mismatch may result from the mismatch error between the two current sources comprised within the first 1-bit current steering DAC and the second 1-bit current steering DAC, respectively. In the case where the signal coupler COU outputs a sum of the received signals, the analogue mismatch signal Vfb may be the addition of the first analogue feedback signal (e.g., Vfb1) and the second analogue feedback signal (e.g., Vfb2), i.e. *Vfb* = *Vfb*1 *+ Vfb2* (which may be expressed as *Vfb =* |*Vfb*1| *+* |*Vfb*2| when the two feedback signals have a same phase, or *Vfb =* |*Vfb*1| *-* |*Vfb*2| when the two feedback signals have an opposite phase).

It should be noted that the terms "first" and "second" are used to distinguish between two components (e.g., two comparators, two 1-bit current steering DACs, two analogue feedback signals) and should not be interpreted as meaning the corresponding numbers. In the context of the present disclosure, the term "first" may correspond to one of "reference" and "calibration" while the term "second" may correspond to the other one of "reference" and "calibration".

During calibration, the analogue mismatch signal Vfb may be relatively small and centered around zero. This may allow the MB-DSM1 to focus on the dynamic useful information contained in a subset of its output bits (e.g., middle-range bits), while the reference and calibration bits may be derived from other bits. In other words, only a subset (e.g., CMP4 to CMP(n-4)) of the N comparators, CMP1, CMP2, ... CMPn, may actually be needed to convert the difference analogue signal Vfb to its corresponding digital signals in a sufficiently accurate manner. The other comparators (e.g., CMP1 to CMP3, or CMP(n-3) to CMPn) that are not used for the data conversion of the difference analogue signal Vfb may be used for outputting calibration signals for calibrating the associated 1-bit current steering DACs. As such, the physical bit lines, BL1, BL2, ... BLn, serve both normal data conversion and calibration modes. If N 1-bit DACs and N comparators are required for full-range data conversion, only the same N 1-bit DACs and N comparators are necessary during calibration. In other words, the proposed MB-DSM1 obviates the need of using any additional 1-bit DACs and/or comparators, as required by the existing calibration techniques.

By way of example and with reference to Table 1, the MB-DSM1 may comprise 11 bit lines which may be formed by 11 comparators and 11 1-bit DACs, respectively. The first column (as indicated by "Normal Operation") of Table 1 corresponds to the normal data conversion mode in which all the 11 bit lines are in the "Active" state, which indicates that all the 11 bit lines are set to have dynamic transitions (e.g., toggling) serving the conversion of the data. The other columns (as indicated by "Calibration line 2 - Calibration line 11") correspond to different implementations of the calibration mode in which only a subset of the 11 bit lines are set to have dynamic transitions while others are either used for calibration or set to a constant logic level. Because the amplitude of such a signal is small and centered around 0, only the middle bit lines 6, 7, 8 may generate dynamic transitions related to the analogue mismatch signal and may be referred to as toggling bit lines. As such, the other bit lines may be used for calibration without affecting the data conversion of the analogue mismatch signal.

For example, as shown in the second column (as indicated by "Calibration line 2") of Table 1, bit line 1 BL1 may be used as a reference bit line and bit line 2 BL2 may be used as a calibration bit line. Accordingly, DAC D1 may be used as a reference DAC and DAC D2 may be used as a calibration DAC (or the DAC under calibration). DAC D1 may receive calibration signal DS1 from the comparator CMP1 and subsequently convert it to analogue feedback signal Vfb1. DAC D2 may receive calibration signal DS2 from comparator CMP2 and subsequently convert it to analogue signal Vfb2. The analogue signal Vfb, as expressed by Vfb = Vfb1 +Vfb2, may be coupled to the input of the integrator and subsequently converted to three 1-bit digital signals, DS6, DS7, DS8, which may be output from comparators CMP6, CMP7, CMP8, respectively and which may pass along bit lines BL6, BL7, BL8, respectively before being received by 1-bit current steering DACs D6, D7, D8, respectively.

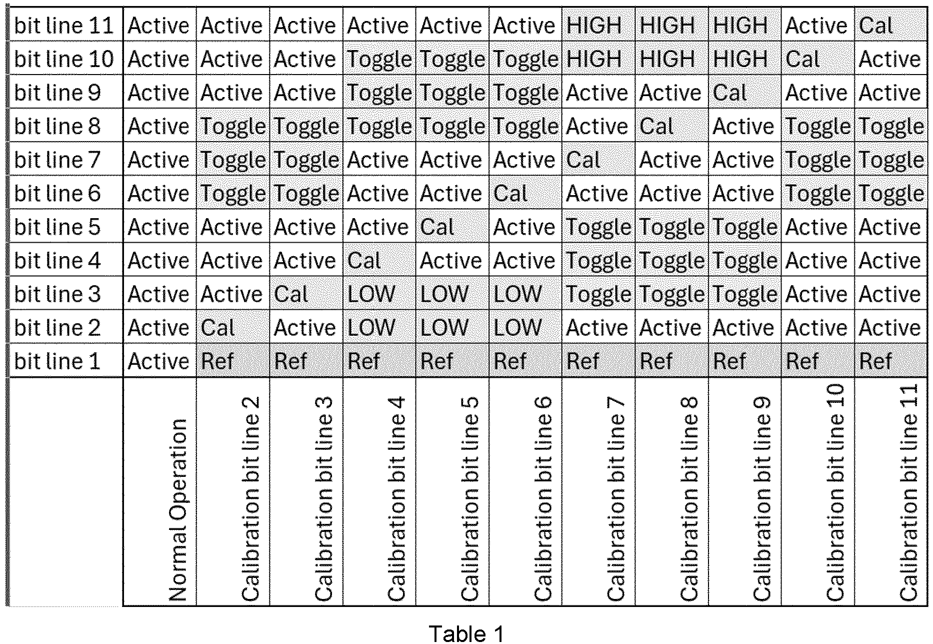

The above calibration process may also be applicable for calibrating other non-toggling bit lines, e.g., BL3, BL10, BL11. It will be appreciated that the reference bit line may not be limited to bit line 1 BL1. Any other bit lines that are not used for converting the analogue mismatch signal may be used as the reference bit line. However, the above calibration process may not be suitable for calibrating the DACs comprised in those toggling bit lines, i.e. BL6, BL7, BL8. For example, calibrating DAC D6 may require shifting up the toggling bit lines (or bit lines with dynamic transitions serving the conversion of the data) to bit lines 8, 9, 10; whereas calibrating DAC D8 may require shifting down the toggling bit lines (or bit lines with dynamic transitions serving the conversion of the data) to bit lines 3, 4, 5. Therefore, an offset mechanism may be required to shift up or down the toggling bit lines to allow calibration of those default toggling bit lines, e.g., bit lines 6, 7, 8.

Accordingly, the MB-DSM1 may comprise an offset mechanism configured to generate an offset at an output of the quantizer QUT to ensure that the reference comparator assembly and the calibration comparator assembly are not required for accurately converting the difference analogue signal into the M 1-bit digital signals. The offset at the output of the quantizer QUT may be generated in different ways depending on the type (e.g., low-pass or band-pass) of the modulator. For low-pass modulators, the offset may be directly introduced at the output of the selected comparator assembly e.g., by applying a forced high or low DC (or constant logic) signal to the comparators. These DC signals may propagate to the input of the modulator, thereby adjusting the behavior of the bit lines. For band-pass modulators, DC signals may not propagate effectively and thus may not be suitable. The offset may be generated using a second FB-DAC whose output is coupled to the integrator's filter chain output.

In an embodiment, the offset mechanism may be operable to force the output of the at least one comparator assembly to a constant logic signal. The at least one comparator may comprise the reference comparator assembly and the calibration comparator assembly.

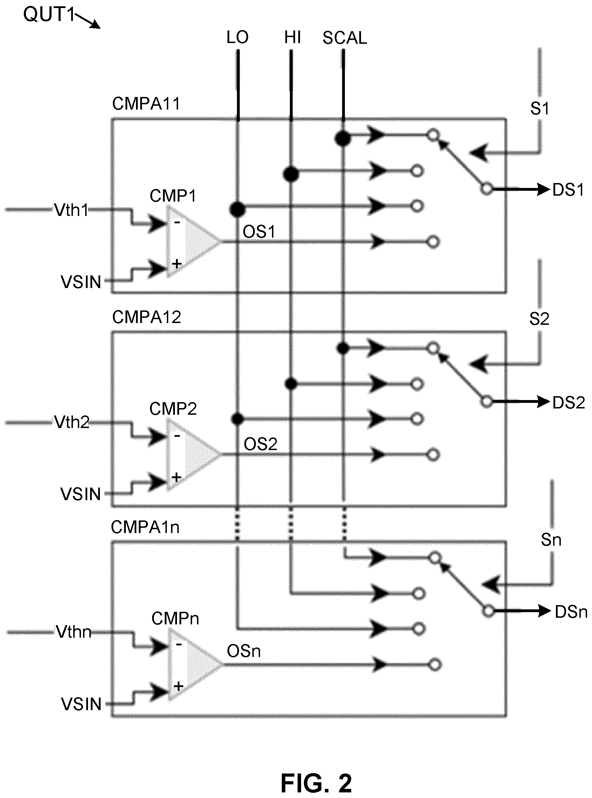

Figure 2 shows a schematic diagram of a first example configuration of the quantizer QUT1 which comprises N first configurable comparator assemblies with configurable output states, CMPA11, CMPA12, ... CMPA1n, which comprise the N comparators, CMP1, CMP2, ... CMPn, respectively.

With reference to Figure 2, each of the first configurable comparator assemblies, CMPA11, CMPA12, ... CMPA1n, further comprises an output multiplexer configured to selectively output an output signal, OS1, OS2, or OSn, of the corresponding comparator, a logic HIGH signal HI, a logic LOW signal LO, or a calibration signal SCAL. For each output multiplexer, the output may be selected by a control signal S1, S2, or Sn. When a lower-bit first configurable comparator assembly (e.g., CMPA12) is forced to output a logic LOW signal LO (i.e. the corresponding output multiplexer selectively outputs the logic LOW signal LO), it may shift the middle toggling bit lines up by one bit line towards higher bit lines (e.g., shifting up the default toggling bit lines 6, 7, 8 to bit lines 7, 8, 9). When a higher-bit first configurable comparator assembly (e.g., those comparator assemblies CMP1n above the toggling bits) is forced to output a logic HIGH signal HI LO (i.e. the corresponding output multiplexer selectively outputs the logic HIGH signal HI), it may shift the middle toggling bit lines down by one bit line towards lower bit lines (shifting down the default toggling bit lines 6, 7, 8 to bit lines 5, 6, 7). By forcing a first configurable comparator assembly (e.g., CMPA11) to output a calibration signal SCAL (i.e. the corresponding output multiplexer selectively outputs the calibration signal SCAL), the associated 1-bit current steering DAC may be used as the reference DAC or the calibration DAC.

In this embodiment, the output multiplexers of the first configurable comparators may function as an offset mechanism.

Including additional output multiplexer in the high-speed signal path may compromise the operational speed of the modulator. Thus, an alternative way of forcing the output of the at least one comparator to a constant logic signal may be desirable.

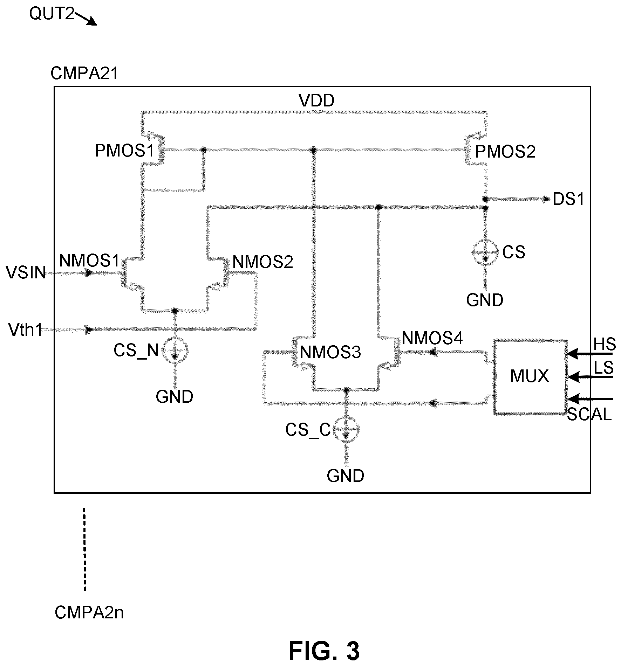

Figure 3 shows a schematic diagram of a second example configuration of the quantizer QUT2 which comprises a plurality of second configurable comparator assemblies with configurable output states, CMPA21, ...CMPA2n, which comprise the N comparators, CMP1, CMP2, ... CMPn, respectively. Since all the second configurable comparator assemblies of the quantizer QUT2 have the same configuration, for the sake of simplicity, Figure 3 only shows the circuit diagram of one comparator assembly, i.e. CMPA21. It will be appreciated that other comparator assemblies will have the same circuit.

With reference to Figure 3, each of the second configurable comparator assemblies, CMPA21, ...CMPA2n, comprises a first parallel differential transistor pair NMOS1 and NMOS2 controlled by a first current source CS_N and a second parallel differential transistor pair NMOS3 and NMOS4 controlled by a second current source CS_C. The first parallel differential transistor pair NMOS1 and NMOS2 may be enabled by enabling the first current source CS_N and the second parallel differential transistor pair NMOS3 and NMOS4 may be enabled by enabling the second current source CS_C. CS_N and CS_C are exclusively enabled. Once enabled, the first parallel differential transistor pair NMOS1 and NMOS2 may be operable to convert the analogue input signal to a respective one of the N 1-bit digital signals, and the second parallel differential transistor pair NMOS3 and NMOS4 may be operable to convert a transistor pair input signal to either a constant logic signal or a calibration signal. Depending on which differential transistor pair is enabled, its output may be the output of the corresponding second configurable comparator assembly, e.g., CMPA21.

With continued reference to Figure 3, the second parallel differential transistor pair NMOS3 and NMOS4 comprises an input multiplexer MUX configured to selectively input, as the transistor pair input signal, a logic HIGH signal HS, a logic LOW signal LS, or a calibration signal SCAL to the differential transistor pair. For each input multiplexer MUX, the input signal may be selected by a control signal (not shown). Thus, when the logic LOW signal LS is selected to be the input of the second parallel differential transistor pair NMOS3 and NMOS4 and the transistor pair NMOS3 and NMOS4 is enabled via CS_C, the second configurable comparator assembly CMPA21 is forced to output the logic LOW signal LS, which may shift the middle toggling bit lines up by one bit line towards higher bit lines (e.g., shifting up the default toggling bit lines 6, 7, 8 to bit lines 7, 8, 9, see Table 1). When the logic HIGH signal HS is selected to be the input of the second parallel differential transistor pair NMOS3 and NMOS4, the second configurable comparator assembly CMPA21 is forced to output the logic HIGH signal HS, which may shift the middle toggling bit lines down by one bit line towards lower bit lines (shifting down the default toggling bit lines 6, 7, 8 to bit lines 5, 6, 7, see Table 1). When the calibration signal SCAL is selected to be the input of the second parallel differential transistor pair NMOS3 and NMOS4, the second configurable comparator assembly CMPA21 is forced to output a calibration signal which will be similar to or substantially same as the input calibration signal SCAL. As such, the associated 1-bit current steering DAC may be used as the reference DAC or the calibration DAC. Accordingly, the offset generated at the output of the quantizer may have different values depending on which two of the comparators are used as the reference comparator and the calibration comparator.

In this embodiment, the second parallel differential transistor pairs (each with an input multiplexer) of the second configurable comparators may function as an offset mechanism. As mentioned above, the first calibration signal output from the reference comparator assembly (e.g., CMPA11 or CMPA21) has a substantially same amplitude as the second calibration signal output from the calibration comparator assembly (e.g., CMPA12 or CMPA22). However, their phases may be same or different.

With reference to Figure 4, in the MB-DSM2, the quantizer QUT may be configured to output two substantially same calibration signals (i.e. substantially same amplitude and phase). It is known that output signal phase inversion can be managed through the control of one of the associated 1-bit current-steering DACs. The first (e.g., reference or calibration) 1-bit current steering DAC (e.g., D1) may be configured to output a first analogue feedback signal (e.g., Vfb1), and the second (e.g., calibration or reference) 1-bit current steering DAC (e.g., D2) may be configured to output a second analogue feedback signal (e.g., Vfb2). The first analogue feedback signal (e.g., Vfb1) and the second analogue feedback signal (e.g., Vfb2) may have opposite phases. In this embodiment, output signal phase inversion may be achieved by the second 1-bit current steering DAC (e.g., D2). The two calibration signals (e.g., DS1, DS2) along with other digital signals (e.g., DS3,...DSn) resulting from converting the analogue mismatch signal Vfb may be fed into a digital signal processor DSP for digital processing the N 1-bit digital signals from the quantizer QUT.

With continued reference to Figure 4, The digital signal processor DSP may comprise a high-pass filter HPF and a calibration processing unit CP. The DC offsets comprised in the N 1-bit digital signals may be filtered out by the high-pass filter HPF. However, if the two substantially identical calibration signals (e.g., DS1, DS2) are coupled into the high pass filter, they may cause artefacts which negatively impact the calibration accuracy. When in the calibration mode, the digital signal processor DSP may be configured to invert the phase or polarity of one (e.g., DS2) of the two calibration signals (e.g., DS1, DS2) so as to remove the calibration induced artefacts. In an example implementation, the digital signal processor DSP may comprise a digital signal inverter INV configured to invert the polarity of a digital input signal. The embodiment shown in Figure 4 may enable an equal delay in the calibration signal injection (as there is no signal inversion in the quantizer) and thus may be suitable for high frequency calibration signals (e.g., in the case of a band-pass MB-DSM requiring a RF carrier).

In an alternative embodiment, the first calibration signal output from the first (e.g., reference or calibration) comparator assembly (e.g., CMPA11 or CMPA21) and the second calibration signal output from the second (e.g., calibration or reference) comparator assembly (e.g., CMPA12 or CMPA22) may have a substantially same amplitude but opposite phases. In such a case, the two associated 1-bit current-steering DACs may have a substantially same configuration (i.e. no output signal phase inversion) and the digital signal processor may not invert one of the two digital input signals coming from the reference and calibration comparator assemblies.

Instead of forcing the output of the at least one comparator to a constant logic signal to generate an offset at the output of the quantizer (e.g., QUT1 or QUT2), it is also possible to generate an offset at the output of the quantizer by applying an offset at the input of the quantizer. Such an offset at the input of the quantizer may translate into an offset at the output of the quantizer.

Accordingly, in an embodiment and with reference to Figure 5, the MB-DSM3 may comprise multiple FB-DACs (e.g., FB-DAC1, FB-DAC2, FB-DAC3), one (e.g., FB-DAC3) of which may be configured to be switchable between the normal mode and the calibration mode. FB-DAC1, FB-DAC2 and FB-DAC3 may each comprise N 1-bit current steering DACs with a substantially same configuration. FB-DAC3 may additionally comprise an input multiplexer configured to selectively input either the output SOUT of the quantizer QUT or a digital offset signal DOS. Such an input multiplexer may allow the FB-DAC3 to be switched between the normal mode and the calibration mode. When in the normal mode, FB-DAC3 may be configured to convert the output SOUT (e.g., comprising the N 1-bit digital signals) received from the quantizer QUT to an analogue feedback signal Vfb_dac3 coupled to the input of the quantizer QUT. When in the calibration mode, FB-DAC3 may be configured to convert the digital offset signal DOS (e.g., comprising N 1-bit digital offset signals) received from e.g., a logic control circuit to an analogue offset signal Vos coupled to an input of the quantizer. Such an analogue offset signal Vos may be converted by the quantizer QUT to a desired offset signal at the output of the quantizer QUT. It will be appreciated that FB-DAC1 has a higher impact in the linearity performance than FB-DAC2 and FB-DAC3 as FB-DAC1 is amplified by two integrators INT1, INT2 whereas FB-DAC2 is amplified only by INT2 and FB-DAC3 is not amplified.

In this embodiment, FB-DAC3 may function as an offset mechanism when in the calibration mode. For both low-pass and band-pass modulators, the calibration signals may always be dynamic signals and may be generated at the output of the quantizer QUT (e.g., in the same manner as shown in Figure 2 or 3). A dynamic calibration signal may be periodic or pseudo-random, or it may be a square wave modulated by a periodic or pseudo-random signal (e.g., a digital-like periodic square wave). On the contrary, the offset signals may always be constant signals (i.e. DC signals) which may transmit through a low-pass modulator but not through (the filter of) a band-pass modulator. Therefore, for low-pass modulators, a constant offset signal (i.e. a DC signal) may be generated at the output of the quantizer (e.g., as shown in Figure 2) which may go through the filter chain and back to the input of the quantizer. For band-pass modulators, the offset signal may be generated at the input of a different FB-DAC (e.g., FB-DAC3 in Figure 5) and may be output at the end of the filter chain (i.e. input of quantizer).

The description provided herein may be directed to specific implementations. It should be understood that the discussion provided herein is provided for the purpose of enabling a person with ordinary skill in the art to make and use any subject matter defined herein by the subject matter of the claims.

It should be intended that the subject matter of the claims is not limited to the implementations and illustrations provided herein, but include modified forms of those implementations including portions of implementations and combinations of elements of different implementations in accordance with the claims. It should be appreciated that in the development of any such implementation, as in any engineering or design project, numerous implementation-specific decisions should be made to achieve a developers' specific goals, such as compliance with system-related and business-related constraints, which may vary from one implementation to another. Moreover, it should be appreciated that such a development effort may be complex and time consuming, but would nevertheless be a routine undertaking of design, fabrication, and manufacture for those of ordinary skill having benefit of this invention.

Reference has been made in detail to various implementations, examples of which are illustrated in the accompanying drawings and figures. In the detailed description, numerous specific details are set forth to provide a thorough understanding of the invention provided herein. However, the invention provided herein may be practiced without these specific details. In some other instances, well-known methods, procedures, components, circuits, and networks have not been described in detail so as not to unnecessarily obscure details of the embodiments.

It should also be understood that, although the terms first, second, etc. may be used herein to describe various elements, these elements should not be limited by these terms. These terms are only used to distinguish one element from another. For example, a first element could be termed a second element, and, similarly, a second element could be termed a first element. The first element and the second element are both elements, respectively, but they are not to be considered the same element.

The terminology used in the description of the invention provided herein is for the purpose of describing particular implementations and is not intended to limit the invention provided herein. As used in the description of the invention provided herein and appended claims, the singular forms "a," "an," and "the" are intended to include the plural forms as well, unless the context clearly indicates otherwise. The term "and/or" as used herein refers to and encompasses any and all possible combinations of one or more of the associated listed items. The terms "includes," "including," "comprises," and/or "comprising," when used in this specification, specify a presence of stated features, integers, steps, operations, elements, and/or components, but do not preclude the presence or addition of one or more other features, integers, steps, operations, elements, components and/or groups thereof.

While the foregoing is directed to implementations of various techniques described herein, other and further implementations may be devised in accordance with the invention herein, which may be determined by the claims that follow. Although the subject matter has been described in language specific to structural features and/or methodological acts, it is to be understood that the subject matter defined in the appended claims is not necessarily limited to the specific features or acts described above. Rather, the specific features and acts described above are disclosed as example forms of implementing the claims.

## Claims

1. A multi-bit delta-sigma modulator 'MB-DSM' comprising:
an integrator configured to receive an analogue input signal and output an integrated analogue signal;
a quantizer configured to receive and convert the integrated analogue signal to N 1-bit digital signals, where N is an integer, wherein the quantizer comprises N comparator assemblies, each comparator assembly configured to at least compare the integrated analogue signal to a corresponding threshold value and output a respective one of the N 1-bit digital signals; and
a first multi-bit feedback digital-to-analog converter 'FB-DAC' configured to convert the N 1-bit digital signals to N analogue feedback signals that are coupled to an input of the integrator, wherein the first multi-bit FB-DAC comprises N 1-bit current steering DACs, each 1-bit current steering DAC configured to convert a respective one of the N 1-bit digital signals to a respective one of the N analogue feedback signals;
wherein the MB-DSM is switchable between
a normal mode in which all the N comparator assemblies are used to convert the analogue input signal to the N 1-bit digital signals, and
a calibration mode in which an analogue mismatch signal derived from a mismatch between a first 1-bit current steering DAC having received a first calibration signal from an associated first comparator assembly of the N comparator assemblies and a second 1-bit current steering DAC having received a second calibration signal having a substantially same amplitude as the first calibration signal from an associated second comparator assembly of the N comparator assemblies is converted into M 1-bit digital signals, where M is an integer and where M<N.

2. A MB-DSM as claimed in claim 1, further comprising an offset mechanism configured to generate an offset at an output of the quantizer to ensure that the first comparator assembly and the second comparator assembly are not required for accurately converting the difference analogue signal into the M 1-bit digital signals and a calibration signal generation mechanism configured to generate calibration signals.

3. A MB-DSM as claimed in claim 2, wherein each of the N comparator assemblies comprises a first parallel differential transistor pair controlled by a first current source and a second parallel differential transistor pair controlled by a second current source; wherein when enabled by the respective current source, the first parallel differential transistor pair is operable to convert the analogue input signal to a respective one of the N 1-bit digital signals and the second parallel differential transistor pair is operable to convert a transistor pair input signal to the first or second calibration signal.

4. A MB-DSM as claimed in claim 3, wherein the second parallel differential transistor pair comprises an input multiplexer configured to selectively receive, as the transistor pair input signal, a logic signal, or an input calibration signal, the input multiplexer functioning as both the calibration signal generation mechanism and the offset mechanism.

5. A MB-DSM as claimed in claim 4, wherein when the second parallel differential transistor pair is enabled and the logic signal is selected as the transistor pair input signal, the corresponding comparator assembly is forced to output a corresponding offset signal, thereby generating the offset at the output of the quantizer.

6. A MB-DSM as claimed in claim 2, wherein each of the N comparator assemblies comprises an output multiplexer configured to selectively output a corresponding 1-bit digital signal or the first or second calibration signal.

7. A MB-DSM as claimed in claim 6, wherein the output multiplexer is further configured to selectively output one of the following signals: the corresponding 1-bit digital signal, the calibration signal, a logic signal, the output multiplexer functioning as both the calibration signal generation mechanism and the offset mechanism.

8. A MB-DSM as claimed in claim 7, wherein when the logic signal is selected as the output of the output multiplexer, the corresponding comparator assembly is forced to output a corresponding offset signal, thereby generating the offset at the output of the quantizer.

9. A MB-DSM as claimed in claim 2, further comprising a second multi-bit FB-DAC comprising N 1-bit current steering DACs and configured to receive in the normal mode the N 1-bit digital signals from the quantizer and in the calibration mode N 1-bit digital offset signals from a logic control circuit and convert either the N 1-bit digital signals from the quantizer or N 1-bit digital offset signals from the logic control circuit to N second analogue feedback signals that are coupled to an input of the quantizer.

10. A MB-DSM as claimed in claim 9, wherein coupling the N second analogue feedback signals into the input of the quantizer in the calibration mode results in the offset at the output of the quantizer.

11. A MB-DSM as claimed in claim 9 or 10, wherein the second multi-bit FB-DAC comprises an input multiplexer configured to selectively receive the N 1-bit digital signals from the quantizer or the N 1-bit digital offset signals from the logic control circuit, thereby enabling the switching between the normal mode and the calibration mode.

12. A MB-DSM as claimed in any preceding claim, wherein the first calibration signal from the first comparator assembly has a same phase as the second calibration signal from the second comparator assembly.

13. A MB-DSM as claimed in claim 12, wherein the first 1-bit current steering DAC is configured to output a first analogue feedback signal, and the second 1-bit current steering DAC is configured to output a second analogue feedback signal, said first analogue feedback signal having an opposite phase to said second analogue feedback signal.

14. A MB-DSM as claimed in claim 12 or 13, further comprising a digital signal processor for processing the N 1-bit digital signals from the quantizer, wherein when in the calibration mode, the digital signal processor is configured to invert the polarity of one of the first calibration signal from the first comparator assembly and the second calibration signal from the second comparator assembly.

15. A MB-DSM as claimed in any of claims 1 to 11, wherein the first calibration signal from the first comparator assembly has an opposite phase to the second calibration signal from the second comparator assembly.

16. A MB-DSM as claimed in any preceding claim, wherein the first calibration signal and the second calibration signal are each a periodic square-wave signal.

17. A method of calibrating a multi-bit delta-sigma modulator 'MB-DSM' as claimed in any preceding claim, the method comprising:
switching the MB-DSM to the calibration mode;
determining that the first comparator assembly and/or the second comparator assembly are required for converting the difference analogue signal into the M 1-bit digital signals; and
generating, by the offset mechanism, the offset at the output of the quantizer such that the first comparator assembly and the second comparator assembly are no longer required for converting the difference analogue signal into the M 1-bit digital signals.
